Europäisches Patentamt

European Patent Office

Office européen des brevets

(19)

(11) Veröffentlichungsnummer : **0 360 348 B1**

(12) # EUROPÄISCHE PATENTSCHRIFT

(45) Veröffentlichungstag der Patentschrift :
31.08.94 Patentblatt 94/35

(51) Int. Cl.⁵ : **G01R 19/25,** G01K 7/02,
G01R 19/00

(21) Anmeldenummer : 89202354.0

(22) Anmeldetag : 18.09.89

(54) **Verfahren und Vorrichtung zur Messung kleiner elektrischer Signale.**

(30) Priorität : **22.09.88 DE 3832145**

(43) Veröffentlichungstag der Anmeldung :
**28.03.90 Patentblatt 90/13**

(45) Bekanntmachung des Hinweises auf die
Patenterteilung :
**31.08.94 Patentblatt 94/35**

(84) Benannte Vertragsstaaten :
**DE FR GB NL**

(56) Entgegenhaltungen :
**DE-A- 3 200 353
DE-A- 3 634 052
TOUTE L'ELECTRONIQUE, Nr. 535, Juni-Juli
1988, Seiten 38-41, Paris, FR;"Système de
mesure thermocouples"
INTERNATIONAL JOURNAL OF ELECTRO-
NICS, Band 58, Nr. 3, März 1985, Seiten
455-462; S.M.R. TAHA: "Fast-reading DVM
with real-time autocalibration"
HEWLETT-PACKARD JOURNAL, Februar
1983, Seiten 3-10; J.P. TRAUTMAN et al.:
"Aportable, low-cost, high-performance digital multimeter for the HP-IL"**

(73) Patentinhaber : **Philips Patentverwaltung
GmbH
Wendenstrasse 35c
D-20097 Hamburg (DE)**
(84) **DE**
Patentinhaber : **N.V. Philips'
Gloeilampenfabrieken
Groenewoudseweg 1
NL-5621 BA Eindhoven (NL)**
(84) **FR GB NL**

(72) Erfinder : **Steinbrecher, Jürgen
Marienburgerstrasse 1
D-3582 Felsberg/Gensungen (DE)**
Erfinder : **Schnell, Ulrich
Unter den Eichen 33
D-3507 Baunatal 1 (DE)**

(74) Vertreter : **Kupfermann, Fritz-Joachim,
Dipl.-Ing. et al
Philips Patentverwaltung GmbH
Wendenstrasse 35
Postfach 10 51 49
D-20035 Hamburg (DE)**

EP 0 360 348 B1

EP 0 360 348 B1

**Beschreibung**

Die Erfindung betrifft ein Verfahren zum Messen kleiner elektrischer Signale mit einer rechnerunterstützten fehlerkorrigierenden Meßschaltung, bei dem erste Meßergebnisse für ein kleinstes und ein größtes zu messendes Signal zwischen einer ersten und zweiten Klemme mindestens eines Einganges der Meßschaltung ermittelt und gespeichert werden, ebenso wie ein erstes Meßergebnis einer Null-Volt-Messung.

Aus dem Artikel mit dem Titel "Système de mesure thermocouples", erschienen in TE-Toute l'Electronique, Nr. 535, Juni - Juli 1988, Seiten 38 - 41, Paris, FR, ist ein Verfahren zu Messen kleiner elektrischer Signale mit einer rechnerunterstützten fehlerkorrigierenden Meßschaltung bekannt, wobei erste Meßergebnisse für ein kleinstes und ein größtes zu messendes Signal zwischen einer ersten und zweiten Klemme mindestens eines Einganges der Meßschaltung ermittelt werden. Bei diesem bekannten Verfahren werden die Meßergebnisse zur weiteren Berechnung herangezogen und einer Recheneinheit zur Berechnung eines korrigierten Anzeigewertes zugeführt, wobei jedoch eine Offset-Fehler-Korrektur nicht möglich ist.

Aus dem weiter bekannten Aufsatz von S.M.R. Taha mit dem Titel "Fast-reading DVM with real-time autocalibration" aus der Zeitschrift International Journal of Electronics, Band 58, Nr. 3, März 1985, Seiten 455-462, ist ferner ein Verfahren zum Messen kleiner elektrischer Signale mit einer fehlerkorrigierenden Meßschaltung bekannt. Zur Eliminierung von Offset-Fehlern bei der Kalibrierung der verschiedenen Meßbereiche werden jeweils eine Null-Volt-Messung durchgeführt und das Ergebnis abgespeichert. Änderungen von Offset-Fehlern lassen sich mit diesem bekannten Verfahren jedoch nicht berücksichtigen.

Ein ähnliches Verfahren sowie eine Vorrichtung zur Durchführung desselben ist aus den Philips-Industriereglern der Type KS 4400 oder KS 4450 bekannt. Diese Geräte weisen beispielsweise eine Schaltung zur Messung von großen Spannungen über einen Spannungsteiler und/oder eine Schaltung zur Messung von Strömen mit einem Shunt auf oder dienen zur Erfassung der Temperatur z.B. einer Flüssigkeit und somit zur Messung von Thermoelementspannungen. Dabei wird die zu messende Spannung mit einem Eingang eines nichtinvertierenden Verstärkers verbunden, während der andere Eingang mit einem Nullpotential verbunden ist. Einem dem Verstärker nachgeschalteten Analog/Digital-Umsetzer (A/D-Umsetzer) wird das Signal übermittelt und anschließend digital zur Anzeige gebracht. Über Potentiometereinstellungen werden der Meßbereichsanfang und das Meßbereichsende unter gleichzeitiger Meßbereichsunterdrückung eingestellt. Ebenfalls über ein Potentiometer wird im Fall der Thermoelementspannungsmessung die Temperaturkompensation eingestellt, und zur notwendigen Linearisierung der Signale ist eine aufwendige analoge Schaltung vorgesehen, die aus mehreren Elementen aufgebaut ist und den Meßbereich in beispielsweise fünf Segmenten linearisiert.

Bei diesem bekannten Verfahren nebst Vorrichtung ist der erhebliche Schaltungsaufwand und der damit verbundene Aufwand bei der Entwicklung einer solchen Vorrichtung nachteilig, insbesondere unter Berücksichtigung von Meßbereichsberechnungsvorschriften. Ferner müssen der Verstärkungs- und der Offsetfehler des Verstärkers und des A/D-Umsetzers kompensiert werden. Zur Verwendung in Geräten des unteren Preisniveaus, die im folgenden auch als sogenannte low-cost-Geräte bezeichnet werden, ist ein solches Verfahren nebst Vorrichtung nicht geeignet. Ein weiterer erheblicher Nachteil ist die Empfindlichkeit gegen die sogenannte Langzeitdrift.

Aus der DE-OS 36 34 052 ist ein Verfahren nebst Schaltungsanordnung zur Widerstandsbestimmung bekannt. Gemäß dieser Schaltungsanordnung ist auf der Eingangsseite eines Multiplexers eine Schaltung aus einer Stromquelle, einem Sensorwiderstand und einem Bezugswiderstand aufgebaut. Zur Bestimmung des Widerstandswertes, also letzlich der Spannung über diesem Widerstand, wird zunächst diese Spannung ermittelt, dann eine Spannung über dem aus der Leitung gebildeten Widerstand und anschließend eine Spannung über dem Bezugswiderstand, um auch den in der Schaltungsanordnung fließenden Strom zu erfassen. Anschließend werden die Eingänge des dem Multiplexer nachgeschalteten Instrumentenverstärkers auf Nullpotential gelegt und über einen A/D-Umsetzer wird dieser Wert für eine Recheneinrichtung digitalisiert. Diese Messung dient dazu, Abweichungen der gemessenen Spannungen durch Temperaturdrift und andere Einflußfaktoren zu bestimmen. Durch Umschaltung des Multiplexers erfolgen diese Messungen wiederholt, so daß in der Recheneinrichtung die erforderliche Berechnung durchgeführt werden kann. Mit Hilfe dieses Verfahrens bzw. dieser Schaltungsanordnung können Offset- und Verstärkungsfehler berücksichtigt werden.

Der vorliegenden Erfindung liegt die Aufgabe zugrunde, ein Verfahren aufzuzeigen, das unter Verwendung von Elementen des unteren Preisniveaus und einer Recheneinrichtung einen geringen hardwaremäßigen Schaltungsaufbau erfordert und unter Berücksichtigung von Offsetfehlern und deren Änderung präzise Meßergebnisse liefert.

Diese Aufgabe wird erfindungsgemäß durch die kennzeichnenden Merkmale des Patentanspruches 1 gelöst.

Das erfindungsgemäße Verfahren dient im wesentlichen zur Messung von elektrischen Strömen, Spannungen und Thermoelementspannungen. Nachdem ein A/D-Umsetzer mit hinreichender Auflösung und Tem-

2

peraturdriftfreiheit einen erheblichen Kostenfaktor darstellt, kommt erfindungsgemäß ein A/D-Umsetzer nach dem Zwei-Rampenverfahren des unteren Preisniveaus, im folgenden auch als sogenannter low-cost-dual-slope-Umsetzer bezeichnet, in Verbindung mit anderen Elementen des unteren Preisniveaus zum Einsatz. Das erfindungsgemäße Verfahren nutzt, um zu präzisen Meßergebnissen zu gelangen, eine auch in preiswerten Meßschaltungen häufig eingesetzte Recheneinrichtung, insbesondere deren Speichereinheit, in besonderer Weise aus. Es beruht darauf, daß neben Einstellpunkten, also Kalibrierwerten bzw. Meßbereichspunkten oder hierzu gehörenden Korrekturwerten, das Ergebnis einer sogenannten Null-Volt-Messung, d.h. Kurzschluß einer verwendeten einem Multiplexer nachgeschalteten Schaltung aus einem Verstärker und dem A/D-Umsetzer, zunächst während des Einstellens des Gerätes in der Fertigung durchgeführt wird und die digitalisierten Signalwerte in eine Recheneinrichtung abgespeichert werden. Die Recheneinrichtung vergleicht dann das Ergebnis einer während des Betriebes durchgeführten erneuten aktuellen Null-Volt-Messung mit dem Ergebnis der abgespeicherten Null-Volt-Messung und korrigiert auf dieser Grundlage die aktuellen Meßwerte. Auf diese Weise ist Freiheit von Offsetfehlern und deren Änderung beim A/D-Umsetzer und Verstärker gewährleistet. D.h. es wird eine Differenz zwischen der Null-Volt-Messung während des Einstellens und während des Betriebes ermittelt, welche der aktuellen Offsetdrift entspricht und zur Fehlerkompensation dient.

Obgleich auch elektrische Ströme indirekt z.B. über einen Shunt erfindungsgemäß gemessen werden können, wird nachfolgend davon ausgegangen, daß ein elektrisches Spannungspotential zu messen ist. Einen Sonderfall bei der Messung von Spannungen stellt die Messung von Thermoelementspannungen dar, weil von dem ermittelten Thermoelementspannungswert der aus einer Klemmentemperaturmessung resultierende Spannungswert subtrahiert werden muß und anschließend, wegen des nichtlinearen Zusammenhanges zwischen Thermoelementspannung und der Temperatur, eine Linearisierung erfolgt. Erfindungsgemäß wird die Messung der Thermoelementspannung unter Berücksichtigung einer Messung für ein kleinstes und ein größtes zu messendes Signal und einer Null-Volt-Messung ermittelt und die Klemmentemperaturmessung nur unter Berücksichtigung von Korrekturwerten, die aus einer Messung für ein kleinstes und größtes zu messendes Temperatursignal resultieren.

Weitere bevorzugte Verfahrensschritte der vorliegenden Erfindung ergeben sich aus den Patentansprüchen 2 bis 8.

Eine erfindungsgemäße Vorrichtung zur Durchführung des beschriebenen Verfahrens nach den Patentansprüchen 1 bis 8 mit einem Multiplexer, einem nachgeschalteten Verstärker, einem Analog/Digital-Umsetzer und einer Recheneinrichtung ist durch den kennzeichnenden Teil des Patentanspruches 9 gegeben.

Diese Vorrichtung bildet eine Meßschaltung, an welche eingangsseitig eine oder mehrere zu messende Spannungen angelegt werden können und ausgangsseitig die gemessene Eingangsgröße an eine Anzeige- oder Regeleinheit weitergegeben werden kann. Entsprechend einer einfachsten Ausführungsform können erfindungsgemäß offsetdriftarme präzise Messungen von Meßsignalen unter Verwendung von Elementen des unteren Preisniveaus dadurch erzeugt werden, daß zwei Umschalter eingangsseitig zum einen an einer Meßspannung anliegen und zum anderen kurzgeschlossen sind und ausgangsseitig an die Eingänge eines Verstärkers, vorzugsweise eines sogenannten Instrumentenverstärkers angeschlossen sind. Diesem Verstärker ist ein sogenannter low-cost-dual-slope-Umsetzer, also ein A/D-Umsetzer nach dem Zwei-Rampenverfahren des unteren Preisniveaus nachgeschaltet. Dieser wandelt die analogen Eingangssignale bei hinreichender Auflösung in entsprechende Digitalwerte um. Dem A/D-Umsetzer ist wiederum eine Recheneinrichtung nachgeschaltet, die entweder eine eigene Anzeigeeinheit beinhaltet bzw. auf eine solche oder auf eine Regeleinheit wirken kann. Gemäß einer besonderen Ausgestaltung der vorliegenden Erfindung kann ein leistungsfähiger sogenannter Microcomputer mit flüchtigen und nichtflüchtigen Speichern verwendet werden. Die nichtflüchtigen Speicher dienen letztlich der Speicherung der Korrekturwerte, die zum Ausgleich von Langzeit- und Temperaturoffsetdriften benötigt werden. Diese Korrekturwerte sind entweder von vornherein bekannt, z.B. wie die Steigung der Kennlinie eines temperaturabhängigen Widerstandes, oder werden durch eine erste Messung, die also dem Einstellen dient, bestimmt. Vorzugsweise werden bei dieser ersten Messung ein kleinster und ein größter zulässiger Wert verwendet, um zugleich die Meßbereichsgrenzen festzulegen. Ein weiterer wesentlicher Korrekturwert wird aus einer ersten Null-Volt-Messung ermittelt und abgespeichert. In der Recheneinrichtung ist ferner mindestens ein Linearisierungsprogramm mit mindestens einer zugehörigen Linearisierungstabelle installiert, um ggf. vorhandene Nichtlinearitäten zwischen Geber- und Meßgröße zu beseitigen.

Um verschiedene Meßsignale verarbeiten zu können, kann der Umschalter durch einen Multiplexer ersetzt werden.

Um bei der Messung einer Thermoelementspannung eine Temperaturkompensation zu gewährleisten, ist mindestens ein weiteres Eingangsklemmenpaar am Multiplexer vorgesehen, an das eine Klemmentemperaturerfassungsschaltung angeschlossen ist. Für diese Klemmentemperaturmessung sind ebenfalls Korrekturwerte ermittelt und im nichtflüchtigen Speicher abgelegt, ebenso wie der Steigungswert der Kennlinie eines beispielhaft verwendeten temperaturabhängigen Widerstandes.

Weitere bevorzugte Ausgestaltungen der vorliegenden Erfindung ergeben sich aus den Patentansprüchen 10, 11 und 12.

Ein Ausführungsbeispiel der Erfindung wird nachfolgend unter Bezugnahme auf eine Zeichnung näher erläutert. Es zeigt:

Fig. 1     eine erfindungsgemäße Vorrichtung zur Messung kleiner elektrischer Signale,

Fig. 2     eine erfindungsgemäße Vorrichtung zur Messung von Thermoelementspannungen, und

Fig. 3     schematisch einen Signalverarbeitungsverlauf der digitalisierten Signale bei einer Vorrichtung nach Fig. 2.

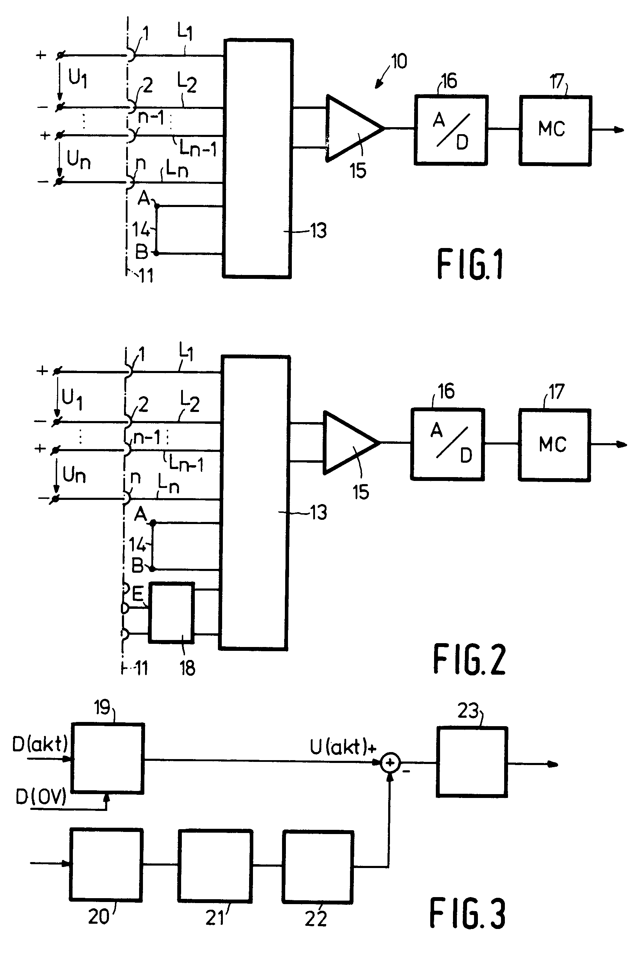

Fig. 1 zeigt eine erfindungsgemäße Meßschaltung 10 bzw. Vorrichtung, welche grundsätzlich zur Messung einer elektrischen Spannung $U_1$ dient, die zwischen Klemmen 1, 2 einer Gehäuseklemmenleiste 11 anliegt. Um mehrere Spannungen, nämlich Spannung $U_1$ bis Spannung $U_n$ zu messen, können Eingangsklemmen 1,2,...,n-1,n an der Geräteklemmenleiste 11 vorgesehen sein. Die Klemmen 1 bis n sind über je eine Leitung $L_1$ bis $L_n$ mit den Eingangsklemmen eines Multiplexers 13 verbunden. Selbstverständlich kann zwischen den jeweiligen Klemmenpaaren ein Shunt vorgesehen sein, um die Messung eines Stromes zu ermöglichen. Der Multiplexer 13 weist ein weiteres Paar Eingangsklemmen A,B auf, die über eine Brücke 14 verbunden sind. Soll nur eine Spannung $U_1$ gemessen werden, dann kann der Multiplexer 13 als doppelter Umschalter ausgebildet sein.

Der Multiplexer schaltet die verschiedenen zu messenden Spannungssignale $U_1$ bis $U_n$ zu einem nachgeschalteten Verstärker 15 durch. Ebenfalls wird zyklisch das Null-Volt-Meßsignal, also das Signal zwischen den Eingangsklemmen A,B des Multiplexers 13 durchgeschaltet. Dies kann seltener geschehen, d.h. nicht bei jedem Durchschalten eines Meßsignals muß das Null-Volt-Meßsignal durchgeschaltet werden. Der Verstärker 15 ist vorzugsweise als Instrumentenverstärker ausgelegt. Dem Verstärker 15 ist ein A/D-Umsetzer 16, vorzugsweise ein low-cost-dual-slope-Umsetzer, nachgeschaltet. Dieser setzt die analog gemessenen Signale in entsprechende digitale Signale um und führt diese dann einer Recheneinrichtung 17 zu. Die Recheneinrichtung 17 kann ein leistungsfähiger kostengünstiger Microcomputer sein, in dem nichtflüchtige und flüchtige Speicher vorhanden und verschiedene Berechnungsprogramme installiert sind. Die Recheneinrichtung 17 kann eine eigene Anzeigeeinheit aufweisen bzw. Daten an eine solche oder eine Regeleinrichtung abgeben.

Um eine Messung durchführen zu können, muß die Meßschaltung 10 erfindungsgemäß eingestellt werden. Dies erfolgt dadurch, daß in der Speichereinheit der Recheneinrichtung 17, nachfolgend mit F gekennzeichnete Einstellwerte abgespeichert werden. So wird für den Meßbereichsanfang M(0%F) der entsprechende Digitalwert D(0%F) zum Zeitpunkt der Einstellung bei einer Gebergröße von 0%, für das Meßbereichsende M(100%F) der entsprechende Digitalwert D(100%F) zum Zeitpunkt der interne Null-Volt-Eingangsspannung U(OVF) der entsprechende Digitalwert D(OVF) zum Zeitpunkt der Einstellung im nichtflüchtigen Speicher abgespeichert. M bezieht sich auf den Meßbereich, d.h. M bedeutet eine Gebergröße Strom, Spannung usw.

Wie bereits erwähnt, werden bei der Einstellung an die Eingangsklemmen 1 bis n die zu den Meßbereichsgrenzen gehörenden Eingangsgrößen für 0% und 100% angelegt und in die Speichereinheit die hierzu gehörenden digitalen Meßwerte D(0%F) und D(100%F) gespeichert. Entsprechend wird mit der Null-Volt-Messung verfahren. Ein aktueller Digitalwert D(akt) für eine nachfolgende Messung hängt dann von der Meßgröße wie folgt ab:

$$D(akt) \;=\; \frac{D(100\%F) - D(0\%F)}{M(100\%F) - M(0\%F)}\, M(akt) \;-\; \frac{D(100\%F) - D(0\%F)}{M(100\%F) - M(0\%F)}\, M(0\%F) \;+\; D(0\%F) \;+\; delta$$

Hierin ist U(OV) eine interne Null-Volt-Meßspannung während des Betriebes und D(OV) der entsprechende Digitalwert. M(akt) ist die aktuelle Meßgröße. Der addierte Term delta repräsentiert einen seit dem Einstellen der Meßschaltung 10 hinzugekommenen Offsetfehler. Der Wert delta ist also die Differenz D(OV) minus D(OVF). Hiermit ergibt sich dann die folgende Bestimmungsgleichung für den Meßwert:

$$M(akt) \;=\; m\,(D(akt) - D(OV)) \;+\; b$$

M kann die gesuchte Spannung oder der gesuchte Strom sein oder als normierte Größe vorliegen. Die Parameter m,b dieser Geradengleichung sind durch die Einstellwerte und Koeffizientenvergleich bestimmbar und dienen als Korrekturwerte für jede folgende Messung. Sollte ein nichtlinearer Zusammenhang zwischen einer Gebergröße und einer Meßgröße bestehen, so wird der endgültige physikalische Wert anschließend mittels eines in der Recheneinrichtung 17 installierten Linearisierungsprogramms und einer Linearisierungstabelle bestimmt.

Fig. 2 zeigt eine bevorzugte Weiterbildung der erfindungsgemäßen Meßschaltung 10 nach Fig. 1. Die Weiterbildung betrifft ein weiteres Paar von Eingängen des Multiplexers 13 zum Anschluß der Ausgangsklemmen einer Klemmentemperatur-Erfassungsschaltung 18. Diese dient der Temperaturkompensation bei der Messung von Thermoelementspannungen an den Klemmen 1 bis n. Die Klemmentemperatur-Erfassungsschaltung 18 weist einen Eingang E auf, welcher thermisch auch zur Berücksichtung einer schnellen Meßfolge mit allen Eingangsklemmenpaaren n-1, n gekoppelt ist. Die Klemmentemperatur-Erfassungsschaltung 18 kann aus einem PTC-Widerstand, einer Stromquelle und aus einem Widerstandsnetzwerk zur Linearisierung des Gebers (T in U) bestehen. Die Spannung ist damit proportional der Klemmentemperatur der Meßschaltung 10. Die Steigung dieses Zusammenhanges sei mptc und steht über einen Speicher der Recheneinrichtung 17 zur Verfügung. Der weitere schaltungstechnische Aufbau der Meßschaltung 10 nach Fig. 2 entspricht dem nach Fig. 1.

Fig. 3 zeigt schematisch die zur Ermittlung einer Fühlertemperatur durchzuführenden Berechnungsschritte. In äquivalenter Weise zu der unter Fig. 1 beschriebenen Berechnung wird über ein Glied 19 die aktuelle Thermoelementspannung U(akt) aus dem digitalisierten aktuellen Spannungsmeßwert D(akt) und dem digitalisierten Null-Volt-Meßwert D(OV) ermittelt. Zur Temperaturkompensation ist hiervon der aus der Klemmentemperaturmessung resultierende Spannungswert zu subtrahieren. Wegen des nichtlinearen Zusammenhangs zwischen einer Thermoelementspannung und einer Temperatur erfolgt eine Linearisierung in Glied 23. Am Ausgang dieses Gliedes 23 steht dann die Fühlertemperatur als Anzeigewert zur Verfügung. Sofern die Spannungen $U_1$ bis $U_n$ aus verschiedenen Thermoelementarten resultieren, können verschiedene Linearisierungstabellen in der Recheneinrichtung 17 installiert sein, die dann entsprechend zum Einsatz gelangen.

Durch Austausch der Größen M durch entsprechende Größen U, also Gebergrößen in mV, in den zu Fig. 1 genannten Bestimmungsgleichungen erhält man die Bestimmungsgleichung

$$U(akt) = mth (D(akt) - D(OV)) + bth$$

für die aktuelle Thermoelementspannung mit der Steigung mth und dem Nulldurchgang bth. Diese Berechnung wird in Glied 19 durchgeführt. Die Ermittlung der aus der Klemmentemperatur resultierenden Spannung wird in den Gliedern 20, 21 und 22 durchgeführt. In Glied 20 wird zunächst die Spannung, resultierend aus dem PTC-Widerstand der Klemmentemperaturerfassungsschaltung 18 berechnet. Ähnlich wie die Eingänge $U_1$ bis $U_n$ wird eine erste Einstellungsmessung unter Berücksichtigung eines kleinsten und eines größten Wertes, allerdings ohne Null-Volt-Messung durchgeführt. Hieraus resultieren die Korrekturwerte mtk und btk, die im Speicher der Recheneinrichtung 17 abgespeichert sind. Das Glied 20 führt dann eine Berechnung nach der folgenden Formel durch:

$$Utk = mtk\, D(akt) + btk$$

Wie bereits erwähnt, ist die Steigung mptc bereits im Speicher der Recheneinrichtung 17 vorhanden, so daß nur noch ein weiterer Punkt benötigt wird, um eine Geradengleichung für die Temperatur angeben zu können. Hierzu kann ein bekanntes vorab ermitteltes Wertepaar, z.B. die Spannung U bei einer bekannten Einstellungstemperatur T, z.B. 25 °C benutzt werden. Die Bestimmungsgleichung lautet dann:

$$T = mptc (U(tk) - U(25)) + T(25)$$

Diese Berechnung wird in Glied 21 durchgeführt. Der Temperaturwert ist zur Anpassung und späteren Subtraktion an die Kennlinie des Thermoelements anzupassen. Nachdem die Temperaturkompensation über einen Spannungswert und nicht über einen Temperaturwert durchgeführt wird, und der Zusammenhang zwischen der durch Glied 21 vorliegenden Temperatur und Spannung nichtlinear ist, wird über das bereits erwähnte Linearisierungsprogramm die Kompensationsspannung in Glied 22 ermittelt. Dieser Wert kann dann von der Thermoelementspannung subtrahiert werden und führt schließlich über die Linearisierung in Glied 23 zum gewünschten Ergebnis.

Gemäß einer weiteren bevorzugten Ausgestaltung der Erfindung kann eine Referenzspannung für das größte und kleinste zu messende Signal vorgesehen sein, die zur Bestimmung der Langzeit- und Temperaturdrift dient, um die aktuellen Meßsignale entsprechend der Gleichung

$$U(akt) = \frac{U(100\%R) - U(0\%R)}{D(100\%R) - D(0\%R)} (D(akt) - D(0\%R)) + U(0\%R)$$

zu korrigieren. R kennzeichnet die zur Referenzspannung gehörenden Werte.

## Patentansprüche

1. Verfahren zum Messen kleiner elektrischer Signale mit einer rechnerunterstützten fehlerkorrigierenden Meßschaltung (10), bei dem erste Meßergebnisse für ein kleinstes und ein größtes zu messendes Signal zwischen einer ersten und zweiten Klemme (n-l,n) mindestens eines Einganges der Meßschaltung (10) ermittelt und gespeichert werden, ebenso wie ein erstes Meßergebnis einer Null-Volt-Messung, dadurch gekennzeichnet, daß jedes weitere Meßergebnis durch eine Signalmessung und durch eine anschließende Vergleichsrechnung nach der Gleichung

$$M(akt) = m (D(akt) - D(OV)) + b$$

mit den gespeicherten ersten Meßergebnissen und mindestens einer weiteren Null-Volt-Messung korrigiert und zur Anzeige gebracht wird, wobei in der Gleichung M(akt) ein aktueller Korrigierter Anzeigewert, D(akt) der entsprechende Digitalwert, D(OV) der Digitalwert der jeweiligen Null-Volt-Messung und m,b Konstanten aus den gespeicherten ersten Meßergebnissen sind.

2. Verfahren nach Anspruch 1,
dadurch gekennzeichnet, daß die elektrischen Signale an den Klemmen (n-1,n) eines Einganges der Meßschaltung (10) von einem Verstärker (15) erfaßt und in einem nachgeschalteten Analog/Digital-Umsetzer (16) in Digitalwerte umgesetzt und einer mit einem Speicher versehenen Recheneinrichtung (17) zur Berechnung des aktuellen korrigierten Anzeigewertes M(akt) zugeführt werden.

3. Verfahren nach Anspruch 1 oder 2,
dadurch gekennzeichnet, daß die während des Meßbetriebes durchgeführte Null-Volt-Messung unabhängig von der Messung des zu messenden Signals durchgeführt wird, und daß die jeweils letzte Messung zur Berechnung verwandt wird.

4. Verfahren nach Anspruch 1, 2 oder 3,
dadurch gekennzeichnet, daß der endgültige physikalische Wert des zu messenden Signals über ein Linearisierungsprogramm mit einer Linearisierungstabelle ermittelt wird, sofern ein nichtlinearer Zusammenhang zwischen dem elektrischen Signal und einer entsprechenden Gebergröße besteht.

5. Verfahren nach einem oder mehreren der vorhergehenden Ansprüche,
dadurch gekennzeichnet, daß von der in der Recheneinrichtung (17) ermittelten korrigierten Spannung U(akt) eines Thermoelements zur Temperaturkompensation eine zusätzlich erfaßte Kompensationsspannung subtrahiert wird, die der Klemmentemperatur entspricht, und daß das hieraus resultierende Signal über ein Linearisierungsprogramm mit einer Linearisierungstabelle in einen zur Anzeige bringbaren Wert für die Fühlertemperatur umgesetzt wird.

6. Verfahren nach Anspruch 5,
dadurch gekennzeichnet, daß die Kompensationsspannung über ein Linearisierungsprogramm mit Linearisierungstabelle ermittelt wird, und daß der jeweilige Eingangstemperaturwert mit Hilfe einer Temperaturerfassungsschaltung (18) für die Klemmentemperatur, einer Korrektur mit Meßbereichsgrenzwerten und einem vorab gemessenen Wertepaar von Spannung und Temperatur über die Recheneinrichtung (17) ermittelt wird.

7. Verfahren nach Anspruch 6,
dadurch gekennzeichnet, daß bei verschiedenen Thermoelementarten jeweils eine entsprechende Linearisierungstabelle in der Recheneinrichtung (17) installiert ist und zur Ermittlung der jeweiligen Anzeigewerte zum Einsatz gelangt.

8. Verfahren nach einem oder mehreren der vorhergehenden Ansprüche,
dadurch gekennzeichnet, daß wiederholt Meßergebnisse für ein dem kleinsten und dem größten zu messenden Signal entsprechendes Referenzsignal ermittelt und einer Vergleichsrechnung zur Driftkorrektur der aktuellen Meßsignale zugeführt werden.

9. Vorrichtung zur Durchführung des Verfahrens zur Messung kleiner elektrischer Signale mit einer rechnerunterstützten fehlerkorrigierenden Meßschaltung nach einem oder mehreren der vorhergehenden Ansprüche 1 bis 8 mit einem Multiplexer, einem nachgeschalteten Verstärker, einem Analog/Digital-Umsetzer und einer Recheneinrichtung,
dadurch gekennzeichnet, daß der Multiplexer (13) mindestens ein Meßsignal-Eingangsklemmenpaar (n-1,n) und ein Null-Volt-Eingangsklemmenpaar (A,B) aufweist und diese wiederholt mit dem nachgeschalteten Verstärker (15) zur Signalerfassung verbindet, und daß ein nichtflüchtiger Speicher in der Recheneinrichtung (17) für die ersten erfaßten und im Analog/Digital-Umsetzer (16) digitalisierten Signale vorhanden ist, und daß für alle weiteren erfaßten und digitalisierten Signale mindestens für die Dauer einer Vergleichsberechnung durch die Recheneinrichtung (17) ein weiterer Speicher installiert ist.

10. Vorrichtung nach Anspruch 9,
dadurch gekennzeichnet, daß an den Meßsignal-Eingangsklemmenpaaren (n-1,n) elektrische Signal-spannungen ($U_n$) anliegen, daß der Verstärker (15) als Instrumentenverstärker ausgelegt ist, und daß in der Recheneinrichtung (17) ein Vergleichsberechnungs- und mindestens ein Linearisierungsprogramm mit mindestens einer Linearisierungstabelle installiert ist, und daß eine Schnittstelle für eine Anzeigeeinrichtung zur Anzeige des ermittelten physikalischen Signalwertes vorhanden ist.

11. Vorrichtung nach Anspruch 10,
dadurch gekennzeichnet, daß die elektrische Signalspannung an einem Meßsignal-Eingangsklemmenpaar (n-1,n) eine Thermoelementspannung ($U_n$) ist, und daß der Multiplexer (13) ein weiteres Eingangsklemmenpaar aufweist, deren Klemmen mit Ausgangsklemmen einer Temperaturerfassungsschaltung (18) verbunden sind, welche eingangsseitig thermisch mit den Meßsignal-Eingangsklemmen (n-1,n) gekoppelt ist, daß in der Recheneinrichtung (17) der nichtflüchtige Speicher auch für die ersten erfaßten und digitalisierten Signale der Temperaturerfassungsschaltung (18), nämlich Signale bei einem kleinsten und größten Signalwert, für ein vorab gemessenes Wertepaar von Temperatur und Spannung und für eine a-priori bekannte Steigung mptc der Temperaturerfassungsschaltung (18) vorgesehen ist, ebenso wie ein flüchtiger Speicher für alle weiteren Signale der Temperaturerfassungsschaltung (18).

12. Vorrichtung nach einem oder mehreren der Ansprüche 9 bis 11,
dadurch gekennzeichnet, daß der Multiplexer (13) Eingangsklemmenpaare aufweist, an denen eine dem kleinsten und dem größten zu messenden Signal entsprechende Referenzspannung anliegt und die Recheneinrichtung (17) ein Programm und Speicher zur Verarbeitung dieser Signale aufweist.

## Claims

1. A method of measuring small electrical signals by means of a computer-aided error-correcting measuring circuit (10) in which first measurement results for a smallest and a largest signal to be measured between a first and a second terminal (n-1, n) of at least one input of the measuring circuit (10) are determined and stored, and also a first measurement result of a zero-volt measurement,
characterized in that each further measurement result is corrected by a signal measurement and a subsequent comparison calculation according to the equation
$$M(akt) = m(D(akt) - C(OV)) + b$$
with the stored first measurement results and at least one further zero-volt measurement, where M(akt) in the equation is a current corrected display value, D(akt) is the corresponding digital value, D(OV) is the digital value of the relevant zero-volt measurement, and m, b are constants from the stored first measurement results, and the corrected value is displayed.

2. A method as claimed in Claim 1,
characterized in that the electrical signals on the terminals (n-1, n) of an input of the measuring circuit (10) are acquired by an amplifier (15) and are converted, in a subsequent analog-to-digital converter (16), into digital values and are applied to an arithmetic device (17), provided with a memory, in order to calculate the current corrected display value M(akt).

3. A method as claimed in Claim 1 or 2,
characterized in that the zero-volt measurement carried out during the measurement operation is effected independently of the measurement of the signal to be measured, and in that each time the last measurement is used for the calculation.

4. A method as claimed in Claim 1, 2 or 3,
characterized in that the ultimate physical value of the signal to be measured is determined via a linearization program with a linearization table in as far as a non-linear relationship exists between the electrical signal and a corresponding quantity.

5. A method as claimed in one or more of the preceding Claims,
characterized in that from the corrected voltage U(akt) of a thermoelement, determined in the arithmetic device (17), an additionally sensed compensation voltage is subtracted for temperature compensation which compensation voltage corresponds to the terminal temperature, and in that the signal resulting therefrom is converted, via a linearization program with a linearization table, into a sensor temperature value that can be displayed.

6. A method as claimed in Claim 5,
characterized in that the compensation voltage is determined, via a linearization program with a linearization table, and in that the respective input temperature value is determined by means of a temperature sensing circuit (18) for the terminal temperature, a correction with measuring range limit values, and a previously measured pair of values of voltage and temperature, by means of the arithmetic device (17).

7. A method as claimed in Claim 6,
characterized in that in the case of different types of thermoelements each time a respective linearization table is installed in the arithmetic device (17) so as to be used for determining the respective display values.

8. A method as claimed in one or more of the preceding Claims,
characterized in that repeatedly measurement results are determined for a reference signal corresponding to the smallest and the largest signal to be measured and are subjected to a comparison calculation for drift correction of the current measurement signals.

9. An apparatus for carrying out the method of measuring small electrical signals, comprising a computer-aided error-correcting measuring circuit as claimed in one or more of the preceding Claims 1 to 8, comprising a multiplexer, a subsequent amplifier, an analog-to-digital converter and an arithmetic device,
characterized in that the multiplexer (13) comprises at least one pair of measuring-signal input terminals (n-1, n) and one pair of zero-volt input terminals (A, B) and repeatedly connects these terminals to the subsequent amplifier (15) for signal sensing, and in that a non-volatile memory is provided in the arithmetic device (17) for the first detected signals, digitized in the analog-to-digital converter (16), and in that for all further detected and digitized signals a further memory is installed at least for the duration of a comparison calculation by the arithmetic device (17).

10. An apparatus as claimed in Claim 9,
characterized in that electrical signal voltages ($U_n$) are present on the pairs of measuring signal input terminals (n-1, n), in that the amplifier (15) is constructed as an instrumentation amplifier, in that a comparison calculation program and at least one linearization program with at least one linearization table are installed in the arithmetic device (17), and in that an interface is provided for display device for displaying the determined physical signal value.

11. An apparatus as claimed in Claim 10,
characterized in that the electrical signal voltage on a pair of measuring signal input terminals (n-1, n) is a thermoelement voltage ($U_n$), in that the multiplexer (13) comprises a further pair of input terminals which are connected to output terminals of a temperature sensing circuit (18) which is thermally coupled, on the input side, to the measuring signal input terminals (n-1, n), in that in the arithmetic device (17) the non-volatile memory is provided also for the first detected and digitized signals of the temperature sensing circuit (18), i.e. signals for a smallest and a largest signal value, for a previously measured pair of values of temperature and voltage and for a priori known rise mptc of the temperature sensing circuit (18), and also a volatile memory for all further signals of the temperature sensing circuit (18).

12. An apparatus as claimed in one or more of the Claims 9 to 11,
characterized in that the multiplexer (13) comprises pairs of input terminals which carry a reference voltage corresponding to the smallest and the largest signal to be measured, and that the arithmetic device (17) comprises a program and memories for processing these signals.

## Revendications

1. Procédé de mesure de petits signaux électriques à l'aide d'un circuit de mesure correcteur d'erreurs assisté par ordinateur (10), dans lequel des premiers résultats de mesure pour le plus petit et le plus grand d'un nombre de signaux à mesurer sont déterminés entre une première borne et une deuxième borne (n-1, n) d'au moins une entrée du circuit de mesure (10) et sont mémorisés, ainsi qu'un premier résultat d'une mesure à tension nulle, caractérisé en ce que chaque autre résultat de mesure est corrigé par une mesure de signal et par un calcul de comparaison suivant, selon l'équation :

$$M(act) = m (D(act) - D(OV)) + b$$

avec les premiers résultats de mesure mémorisés et au moins une autre mesure à tension nulle et est affiché, étant entendu que, dans l'équation M(act) est une valeur d'affichage corrigée actuelle, D(act) est la valeur numérique correspondante, D(OV) est la valeur numérique de la mesure respective à tension nulle et m, b sont des constantes provenant des premiers résultats de mesure mémorisés.

2. Procédé selon la revendication 1, caractérisé en ce que les signaux électriques sont détectés aux bornes (n-1, n) d'une entrée du circuit de mesure (10) par un amplificateur (15), sont convertis dans un convertisseur analogique/numérique (16) monté en aval en valeurs numériques et sont acheminés à un dispositif de calcul (17) pourvu d'une mémoire, pour calculer la valeur d'affichage corrigée actuelle M(act).

3. Procédé selon la revendication 1 ou 2, caractérisé en ce que la mesure à tension nulle effectuée en cours de mesure est réalisée indépendamment de la mesure du signal à mesurer et que la dernière mesure est chaque fois utilisée pour le calcul.

4. Procédé selon la revendication 1, 2 ou 3, caractérisé en ce que la valeur physique finale du signal à mesurer est déterminée via un programme de linéarisation avec un tableau de linéarisation pour autant qu'il y ait une relation non linéaire entre le signal électrique et une grandeur détectée correspondante.

5. Procédé selon une ou plusieurs des revendications précédentes, caractérisé en ce que l'on soustrait de la tension corrigée U(act) d'un thermocouple obtenue dans le dispositif de calcul (17), à des fins de compensation de température, une tension de compensation détectée en sus, qui correspond à la température des bornes, et que le signal qui en résulte est converti via un programme de linéarisation avec un tableau de linéarisation en une valeur qui peut être affichée pour la température du capteur.

6. Procédé selon le revendication 5, caractérisé en ce que la tension de compensation est déterminée via un programme de linéarisation avec un tableau de linéarisation, et en ce que la valeur respective de la température d'entrée est déterminée à l'aide d'un circuit de détection de température (18) pour la température des bornes, d'une correction avec des valeurs limites du domaine de mesure et d'une paire de valeurs de tension et de température mesurées précédemment via le dispositif de calcul (17).

7. Procédé selon la revendication 6, caractérisé en ce que, dans le cas de différents thermocouples, un tableau de linéarisation correspondant est chaque fois installé dans le dispositif de calcul (17) et est mis en oeuvre pour déterminer les valeurs d'affichage respectives.

8. Procédé selon une ou plusieurs des revendications précédentes, caractérisé en ce que l'on détermine de manière répétée des résultats de mesure pour un signal de référence correspondant au plus petit et au plus grand signal à mesurer et on les soumet à un calcul de comparaison pour corriger la dérive des signaux de mesure actuels.

9. Dispositif pour l'exécution du procédé de mesure de petits signaux électriques à l'aide d'un circuit de mesure correcteur d'erreurs assisté par ordinateur selon une ou plusieurs des revendications 1 à 8, comportant un multiplexeur, un amplificateur monté en aval, un convertisseur analogique/numérique et un dispositif de calcul, caractérisé en ce que le multiplexeur (13) présente au moins une paire de bornes d'entrée de signaux de mesure (n-1, n) et une paire de bornes d'entrée à tension nulle (A, B) et celle-ci se raccorde de manière répétée à l'amplificateur monté en aval (15) pour détecter des signaux et qu'une mémoire non volatile est présente dans le dispositif de calcul (17) pour les premiers signaux captés et numérisés dans le convertisseur analogique/numérique (16), et que, pour tous les autres signaux captés et numérisés, une autre mémoire est installée au moins pour la durée d'un calcul de comparaison via le dispositif de calcul (17).

10. Dispositif selon la revendication 9, caractérisé en ce que sont appliqués aux paires de bornes d'entrée de signaux de mesure (n-1, n) des signaux de tension électrique ($U_n$), que l'amplificateur (15) se présente sous la forme d'un amplificateur instrumental, qu'est installé dans le dispositif de mesure (17) un programme de calcul de comparaison et au moins un programme de linéarisation avec au moins une table de linéarisation, et qu'une interface destinée au dispositif d'affichage est présente pour afficher la valeur du signal physique obtenu.

11. Dispositif selon la revendication 10, caractérisé en ce que le signal de tension électrique appliqué à la paire de bornes d'entrée de signaux de mesure (n-1, n) est une tension de thermocouple ($U_n$), que le multiplexeur (13) présente une autre paire de bornes d'entrée dont les bornes sont raccordées aux bornes de sortie d'un circuit de détection de température (18) et sont reliées, côté entrée, thermiquement aux bornes d'entrée de signaux de mesure (n-1, n), que, dans le dispositif de mesure (17), la mémoire non volatile est prévue également pour les premiers signaux détectés et numérisés du circuit de détection de température (18), à savoir les signaux correspondant à une valeur de signal la plus petite et à une valeur de signal la plus grande, pour une paire de valeurs mesurées précédemment de la température et de la tension et pour une augmentation mptc connue à priori du circuit de détection de température (18), ainsi qu'une mémoire volatile pour tous les autres signaux du circuit de détection de température (18).

12. Dispositif selon une ou plusieurs des revendications 9 à 11, caractérisé en ce que le multiplexeur (13) présente des paires de bornes d'entrée auxquelles s'applique une tension de référence correspondant au plus petit signal et au plus grand signal à mesurer et le dispositif de calcul (17) comporte un programme et des mémoires pour traiter ces signaux.

FIG.1

FIG.2

FIG.3